(19) Europäisches Patentamt
European Patent Office
Office européen des brevets

(11) Publication number: 0 191 947 B1

# (12) EUROPEAN PATENT SPECIFICATION

(45) Date of publication of patent specification: 29.05.91 (51) Int. Cl.⁵: G01R 29/02

(21) Application number: 85116473.1

(22) Date of filing: 23.12.85

## (54) An apparatus for compensating a quantization error.

(30) Priority: 25.12.84 JP 279428/84

(43) Date of publication of application: 27.08.86 Bulletin 86/35

(45) Publication of the grant of the patent: 29.05.91 Bulletin 91/22

(84) Designated Contracting States: AT DE FR GB NL

(56) References cited: DE-A- 2 319 897

(73) Proprietor: SONY CORPORATION
7-35 Kitashinagawa 6-Chome Shinagawa-ku
Tokyo 141(JP)

(72) Inventor: Nagai, Yasuo c/o Sony Corporation
7-35, Kitashinagawa 6-chome Shinagawa-ku
Tokyo(JP)
Inventor: Abe, Fumiyoshi c/o Sony Corporation
7-35, Kitashinagawa 6-chome Shinagawa-ku
Tokyo(JP)

(74) Representative: Schmidt-Evers, Jürgen, Dipl.-Ing. et al
Patentanwälte Dipl.-Ing. H. Mitscherlich Dipl.-Ing. K. Gunschmann Dipl.-Ing. Dr.rer.nat. W. Körber Dipl.-Ing. J. Schmidt-Evers Dipl.-Ing. W. Melzer Steinsdorfstrasse 10
W-8000 München 22(DE)

EP 0 191 947 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

### Field of the Invention

This invention relates generally to an apparatus for compensating a quantization error and more particularly is directed to an apparatus for compensating a quantization error for use with a servo system of a video tape recorder (VTR).

### Description of the Prior Art

In the prior art, a time information detecting apparatus which detects a time information such as a pulse width of a pulse signal is employed in various kinds of apparatus and which is also applied to a servo system for a motor of a video tape recorder (VTR).

In the VTR, as shown in Fig. 1 in order to rotate a DC motor 1 such as a drum motor, a capstan motor and so on at a steady rotational speed, the rotational speed of the motor 1 is detected by a frequency generator (FG) 2 and a control voltage signal corresponding to the detected rotational speed (time information) is generated by a time information apparatus 3 and is supplied through a motor drive amplifying circuit 4 to the motor 1.

As the time information detecting apparatus 3 used in such speed servo system, there is known such one that is constructed as shown in Fig. 2.

Referring to Fig. 2, a time signal VEL (Fig. 3A) consisting of a pulse signal from the frequency generator 2 (Fig. 1) is supplied to a delay circuit 5 and to a sampling pulse generator circuit 8. The delay circuit 5 generates a timing delay signal DLY (Fig. 3B), which rises to logic level "H" during a predetermined time T0 from every other rising-up time point t1 of the time signal VEL to the logic level "H" and supplies the signal DLY to a slope generator circuit 6. The slope generator circuit 6 supplies to a sample and hold circuit 7 a voltage signal V which gradually and rectilinearly increases in voltage value from a time point t2 at which the timing delay signal DLY is fallen to a logic "L" as shown in Fig. 3C.

A sampling pulse generator circuit 8 receives the time signal VEL, detects a rising edge time point t3 of the time signal VEL delayed by a delay amount of one period TX from the timing point t1 at which the timing delay signal DLY rises to the logic "H", produces a sampling pulse signal SMP shown in Fig. 3D and supplies the sampling pulse signal SMP to the sample and hold circuit 7.

The sample and hold circuit 7 is adapted to sample and to hold the value of the voltage signal V when the sampling pulse signal SMP is applied thereto and generates the value thereof as a control voltage signal VCON (Fig. 3C).

Consequently, according to the time information detecting apparatus 3 in Fig. 2, when the motor 1 is rotated at a speed higher than a predetermined rotational speed, the period TX of the time signal VEL becomes short and hence the sampling pulse signal SMP is delivered at an early time point, so that the sample and hold circuit 7 produces the control voltage signal VCON of a low level. On the other hand, when the motor 1 is rotated at a rotational speed lower than the predetermined rotational speed, the period TX of the time signal VEL becomes long so that the sample and hold circuit 7 produces the control voltage signal VCON of a high level.

Therefore, the motor 1 is controlled so as to be rotated at the same rotational speed.

However, if such time information detecting apparatus 3 is formed as an analogue circuit arrangement, there occurs a defect that the output voltage signal will fluctuate due to the change of ambient temperature, the fluctuation of a power supply source voltage and so on, and hence the voltage is unstable.

For this reason, it may be considered that this time information detecting apparatus 3 be formed as a digital circuit arrangement. According to such digital time information detecting apparatus, since the time information of the analogue amount is digitized, a quantization error occurs so that the accuracy of the output signal is restricted by this quantization error. Accordingly, in order to control, for example, the motor stably, a high clock frequency must be selected.

For example, if a drum motor in which the period of the pulse signal VEL from the frequency generator 2 is 50$\mu$s is stably controlled at an accuracy of within 0.02%, it is necessary to detect the period as accurately as better than one in 5000 counts. This requires the clock frequency expressed by the following Eq. (1)

$$1/50\ (\mu s) \times 5000 = 100\ (MHz) \quad \ldots (1)$$

However, since the maximum operation frequency of a digital IC widely used lies in a range from about 10 to 20 MHz, if the clock frequency of 100 MHz is intended to be realized, there is a fear that a digital IC, which can be applied to such purpose, will not be obtained in practice. Further, even if the clock frequency of 100 MHz may be realized, the apparatus becomes complicated in construction and large in size because many interface circuits are required by each circuit. Furthermore it is power consuming, and therefore the considered apparatus is not suitable in practice.

Accordingly it is an object of the present invention to provide an apparatus for compensating for a quantisation error which can stably operate regardless of the change of temperature, of the fluctuation of the power source voltage and so on, which further can produce a detected value of high resolution and is particularly suitable for use with a servo system of a video tape recorder.

According to the present invention there is provided an apparatus for detecting a pulse width of a pulse signal comprising:

input pulse source means for generating said pulse signal;

means for generating reference clock pulses;

means for producing a synchronized pulse signal by synchronizing the leading and trailing edges of said original pulse signal to the respective next occuring leading edge of said reference clock pulses,

detecting means for detecting a timing difference between the leading/trailing edges of said original pulse signal and said synchronized pulse signal, respectively, said detecting means including

- a first detector for detecting a first timing difference between the leading edge of said synchronized pulse signal and the leading edge of said original pulse signal and for producing a first output signal whose pulse width indicates said first timing difference, and
- a second detector for detecting a second timing difference between the trailing edge of said synchronized pulse signal and the trailing edge of said original pulse signal and for producing a second output signal whose pulse width indicates said second timing difference;

  a converting circuit for converting said first and second output signals into an analogue signal which corresponds to the difference between the duration of said first and second output signals and thereby to the timing difference between said original pulse signal and said synchronized pulse signal;

  counting means arranged for counting the reference clock pulses appearing during the existence of said synchronized pulse signal and producing a count value indicating pulse width of said synchronized pulse signal; and

  compensating means for compensating said count value in response to said analogue signal, and
- having digital-to-analogue converting means for digital-to-analogue converting said count value and analogue adding means for adding said analogue value and the output of said digital-to-analogue converting means,
- or having analogue-to-digital converting means for analogue-to-digital converting said analogue data and digital adding means for adding said count value and the output of said analogue-to-digital converting means,

  said compensating means generating a pulse width signal having a less quantization error.

The present invention will be understood more fully from the detailed description given herebelow and from the accompanying drawings of a preferred embodiment.

In the drawings:

Fig. 1 is a block diagramm showing a circuit arrangement of a case in wich a prior art information detecting apparatus is applied to a motor speed control apparatus;

Fig. 2 is a block diagramm showing an example of a prior art time information detecting apparatus;

Fig. 3A to 3D are timing charts useful for explaining the operation of the apparatus of Fig. 2, respectively;

Fig. 4 is a block diagram showing an embodiment of an apparatus for compensating for a quantization error according to the present invention;

Figs. 5A to 5G are timing charts useful for explaining the operation of the apparatus shown in Fig. 4, respectively; and

Fig. 6 is a block diagram showing another embodiment of the present invention.

## DESCRIPTION OF THE PREFERRED EMBODIMENTS

Now, the present invention will hereinafter be described with reference to the attached drawings, in which the present invention is applied to the speed servo system of a VTR. Fig. 4 is a block diagram showing an embodiment of an apparatus for compensating for a quantization error according to this invention.

Referring to Fig. 4, two frequency generators 2A and 2B are mounted on a drum motor 1 such that phases of output signals S2A and S2B from the frequency generators 2A and 2B become different from each other by 90°. The output signals S2A and S2B from the frequency generators 2A and 2B are supplied to comparator circuits 10A and 10B, respectively.

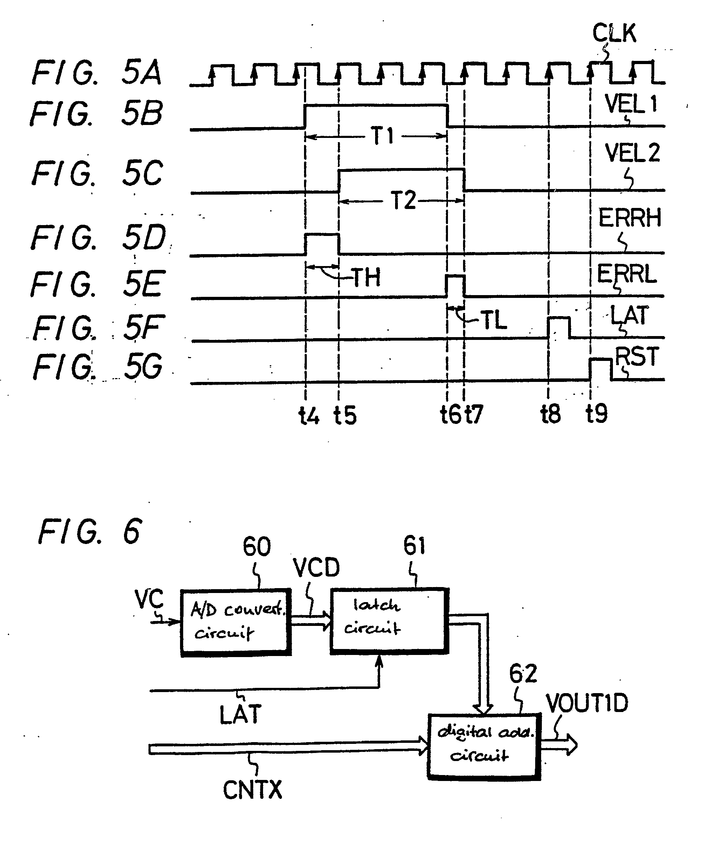

The comparator circuits 10A and 10B compare the output signals S2A, S2B with a reference voltage VREF and reshape them into pulse signals S10A and S10B, respectively. The pulse signals S10A and S10B reshaped are fed to an exclusive-OR signal circuit 11. The exclusive-OR circuit 11 supplies an exclusive-OR signal of the pulse signals S10A and S10B to a time information detecting apparatus 20 as an original time signal VEL1 which is to be detected (Fig. 5D).

In the time information detecting apparatus 20, a D-type flip-flop circuit 31 in a time detector circuit 30 is supplied at its data input terminal D with the original time signal VEL1 and at its clock input terminal with a clock signal CLK having a frequency of 7 MHz (Fig. 5A). This flip-flop circuit 31 is triggered at the leading edge of the clock signal CLK, generating a synchronized time signal VEL2 (Fig. 5C), which is provided by synchronizing the original time signal VEL1 with the clock signal CLK, as a Q output. This signal VEL2 is fed to a 2-input AND circuit 32 at one input terminal as a gating signal.

Since the AND circuit 32 is supplied at the other input terminal with the clock signal CLK, the AND circuit 32 allows the clock signal CLK to pass therethrough during a period T2 in which the synchronized time signal VEL2 rises to the logic level "H". The clock signal CLK therefrom is fed to a counter 33.

The counter 33 is adapted to carry out the count operation each time the clock signal CLK is supplied thereto and a latch circuit 34 latches the counted value of the counter 33 when the latch circuit 34 is supplied with a latch signal LAT (Fig. 5F) and delivers the same to a D/A (digital-to-analogue) converter circuit 35.

The D/A converter circuit 35 converts a latched output CNTX from the latch circuit 34 to an analogue signal and delivers the same as an output signal VOUT0 from a time detector circuit 30. This signal VOUT0 is supplied through an adder circuit 52 and the motor drive amplififying circuit 4 to the motor 1 as the speed control signal.

A reset signal RST (Fig. 5G) for resetting the counter 33 and the latch signal LAT for specifying the latch timing of the latch circuit 34 are both generated from a control signal generator circuit 36. The control signal generator circuit 36 receives the synchronized time signal VEL2 and the clock signal CLK, detects the trailing edge of the synchronized time signal VEL2 and supplies to the latch circuit 34 the latch signal LAT (Fig. 5F) which rises up at a time point t8 succeeding to a falling down time point t7 of the synchronized time signal VEL2 in synchronism with the clock signal CLK.

Accordingly, the counted value CNTX of the counter 33 at the time point t8 at which the latch signal LAT is fed to the counter 33 becomes the value corresponding to the high period T2 of the synchronized time signal VEL2. When the motor 1 is rotated at a rotational speed higher than the predetermined rotational speed, the high period T2 is short so that the counted value CNTX which is latched is small and hence the speed control signal VOUT0 of a low level is fed back to the motor 1. When on the other hand the motor 1 is rotated at a rotational speed lower than the predetermined rotational speed, the rising-up period T2 becomes longer so that the counted value CNTX is large and hence the speed control signal VOUT0 of a high level is fed back to the motor 1.

The control signal generator circuit 36 generates the reset signal RST (Fig. 5G) which rises up at a time point t9 delayed from the time point t8 at which the latch signal LAT is produced, in synchronism with the clock signal CLK. Accordingly, the counter 33 is reset after the latch operation was carried out by the latch circuit 34 positively. The output time point t9 of the reset signal RST is selected to be preceding a time point at which the synchronized time signal VEL2 rises up next time.

Although in Fig. 4 it may be considered that as the gating signal for controlling the AND circuit 32 to open, the original time signal VEL1 could be directly used to allow the clock signal CLK to pass during the rising-up time period thereof and to be fed to the counter 33, if the time signal VEL2, which is provided by synchronizing the original time signal VEL1 with the clock signal CLK, is used as the gating signal as shown in Fig. 4, it is possible to prevent the original number of the clock signals CLK passing during the high period T1 of the original time signal VEL1 from being increased or decreased.

By the way, the high period TI of the original time signal VEL1 is the analogue amount which continuously varies with the change of the rotational speed of the motor 1. Whereas, the time period appearing on the practically detected value, i.e., the high period T2 of the synchronized time signal VEL2 becomes a time period equal to a time period, which is provided by multiplying the period of the clock signal CLK, and which changes stepwise. Consequently, as shown in Figs. 5D and 5E, quantization error time periods TH and TL occur in the rising-up and falling-down portions of the original time signal VEL1. The apparatus for compensating for a quantization error shown in Fig. 4 includes, in addition to the above mentioned circuit arrangement, a quantization error detector circuit 40 for detecting the quantization error time periods and a compensator circuit 50 for compensating for such errors.

In the quantization error detector circuit 40, 2-input AND circuits 41 and 42 are adapted to detect the error time period TH at the rising edge portion and the error time TL at the falling-down portion of the original time signal VEL1, respectively.

The AND circuit 41 is supplied at its one input terminal with the original time signal VEL1 (Fig. 5B) and at its other input terminal with an inverted signal $\overline{VEL2}$of the synchronized time signal VEL2 (Fig. 5C). Accordingly, the AND circuit 41 produces a leading edge error time signal ERRH (Fig. 5D) which is delivered to a first constant current circuit 43. On the other hand, the AND circuit 42 is supplied at its one input terminal with an inverted signal VEL1 of the original time error signal VEL1 and its other input terminal with the synchronized time signal VEL2. Thus the AND circuit 42 produces a trailing edge error time signal ERRL (Fig. 5E) which is delivered to a second constant current circuit 44.

The first constant current circuit 43 is adapted to supply a constant current I0 to a capacitor C and to charge it during the leading edge error time period TH in which the leading edge error time signal ERRH rises up to the logic "H". While, the second constant current circuit 44 is adapted to flow a constant current I1 so as to discharge the capacitor C during the trailing edge error time period TL in which the trailing edge error time signal ERRL rises up to the logic "H". Accordingly, a voltage $V_C$ across the capacitor C after the charging and discharging operations of the capacitor C were ended takes a voltage value corresponding to a time difference (TH - TL) between the leading error time period TH and the trailing error time period TL. Since the time period difference (TH - TL) is equal to the time period difference (T1 - T2) between the high period T1 of the original time signal VEL1 and the high period T2 of the synchronized time signal VEL2, a voltage value corresponding to a total quantization error time period (T1 - T2) remains in the capacitor C. This residual voltage $V_c$ is supplied to the compensator circuit 50 as an error time period detecting voltage signal.

The capacity of the capacitor C and the constant currents I1 and I0 flowing through the capacitor C are selected such that the residual voltage of the capacitor C per unit time may become equal to a voltage of the speed control signal VOUT0 generated from the D/A converter circuit 35 per unit time.

In the compensator circuit 50, a sample and hold circuit 51 is adapted to sample and hold the error time period detecting voltage signal $V_C$ from the capacitor C and to deliver the same thus held to an adder circuit 52 when it is supplied with the latch signal LAT (Fig. 5F) from the control signal generator circuit 36.

Accordingly, the adder circuit 52 compensates for the quantization error by adding the control voltage signal VOUT0 corresponding to the high period T2 of the synchronized time signal VEL2 with the voltage signal VC corresponding to the quantization error time period (T1 - T2). Thus, the adder circuit 52 produces the control voltage signal VOUT1 corresponding to the rising-up time period T1 of the original time signal VEL1.

Further in Fig. 4, a switching circuit 45 is connected in parallel to the capacitor C. when this switching circuit 45 is supplied with the reset signal RST (Fig. 5G) from the control signal generator circuit 36, it is closed during a predetermined time period. Due to the closing operation of the switching circuit 45, the capacitor C completely discharges the accumulated charges and is placed in the standby mode for the charge and discharge operation of the next period of the original time signal VEL1.

According to the circuit arrangement of Fig. 4, when the motor 1 is rotated and hence the original time signal VEL1 is supplied to the time information detecting apparatus 20, in the time information detecting apparatus 20, the original time signal VEL1 is synchronized with the clock signal CLK by the D-type flip-flop circuit 31 and then the high period T2 of the synchronized time signal VEL2 is counted by the counter 33. The counted value is latched by the latch circuit 34 at the time point t8 and is then converted to the analogue voltage signal VOUT0 by the D/A converter circuit 35, which is then fed to the adder circuit 52.

When the original time signal VEL1 is fed to the time information detecting apparatus 20, in the quantization error detecting apparatus 40, the rising error time signal ERRH is supplied from the AND circuit 41 to the constant current source circuit 43 during the error time period TH from the time point t4, driving the constant current circuit 43 so as to charge the capacitor C. Then, during the error time period TL from the time point t6, the trailing edge error time signal ERRL is supplied from the AND circuit 42 to the constant current circuit 44, driving the constant current circuit 44 so as to discharge the capacitor C. Thereafter, at the time point t8, the voltage $V_C$ across the capacitor C is sampled and then held by the sample and hold circuit 51, which is then delivered to the adder circuit 52.

Accordingly, from the time point t8, the adder circuit 52 produces the speed control signal VOUT1 the quantization error component of which is compensated for by adding the voltage signal VC to the speed control signal VOUT0. This speed control signal VOUT1 is fed back through the amplifying circuit 4 to the motor 1, by which the motor 1 is controlled.

Thereafter, at the time point t9, the reset signal RST is fed to the counter 33 and the switching circuit 45, clearing the counted value of the counter 33 and restoring the value of the voltage across the capacitor C to the reference value (for example, 0V), thus setting the time information detecting apparatus 20 in a standby mode for the next period of the original time signal VEL1.

As described above, according to the apparatus of Fig. 4, the quantization time period error (TH - TL)(= T1 - T2) is detected in the form of the analogue amount as the voltage $V_C$ across the capacitor C and the time signal VOUT0 measured in a digital fashion is compensated for by this detected amount, so that it is possible to obtain a measuring time which is accurate enough for the measuring time of the original time signal VEL1. In this case, if the accuracy sufficient for the practical use is merely obtained by the apparatus of digital circuit arrangement, it is necessary to select the frequency of the clock signal CLK to be, for example, 100 MHz that can not be realized. However, since the apparatus for compensating for a quantization error of the present invention includes the quantization error detector circuit 40 and the compensator circuit 50, in order to achieve the same accuracy, it is sufficient to select the frequency of the clock signal CLK to be, for example, about 7 MHz. Thus, the circuit arrangement can be made practical and simple in construction.

According to the circuit arrangement of Fig. 4, since the time signal detected with high accuracy is used as the speed control signal of the motor 1, it is possible to increase the accuracy of the rotational speed of the motor 1.

While in the above mentioned embodiment the time information detecting apparatus 20 is applied to the speed control apparatus of the motor 1, the present invention is not limited to the above mentioned apparatus but can be widely applied to such apparatus which must be arranged such that the time of a time signal is measured and then delivered as an electrical signal. For example, this invention can be applied to such control apparatus that a phase difference between two signals is measured as a time signal and the control operation is carried out so as to remove such phase difference. Also, the present invention can be applied to a case in which a time signal to be measured is such one with a total amount of more than two rising periods.

Further, while in the above mentioned embodiment the time signal, which is measured by the digital circuit arrangement and is compensated for by the analogue circuit arrangement, is delivered in the form of the analogue amount from the output stage, the present invention is not limited to the above mentioned embodiment but can be applied to a case in which such signal is produced in the form of digital amount from the output stage in accordance with the usage. For example, when a detected time signal is supplied to a display apparatus so as to display the measured time thereon, it is practical to generate the time signal in the form of the digital amount.

When the measured time signal is delivered in the form of the digital amount, instead of the circuit arrangement formed of the D/A converter circuit 35, the analogue adder circuit 52 and the sample and hold circuit 51 shown in Fig. 4, there can be used such a circuit arrangement as shown in Fig 6 showing a main part of another embodiment of according to the present invention. In the apparatus of Fig. 6, the voltage $V_C$ across the capacitor C (Fig. 4) is converted to a digital signal VCD by an A/D converter circuit 60. The digital signal VCD is latched by the latch circuit 61 at the timing of the leading edge of the latch signal LAT and the digital signal latched is added to the latch output CNTX from the latch circuit 34 (Fig. 4) in a digital adder circuit 62 and thereby the measured time is delivered as a digital signal VOUT1D.

According to the present invention as set forth above, since the time signal can be measured by means formed of the digital circuit arrangement and the quantization error caused upon the measurement can be detected and compensated for by means formed of the analogue circuit arrangement, the apparatus of the invention can stably be operated regardless of the change of temperature and the fluctuation of the power supply voltage. In this case, although the means formed of the digital circuit arrangement is employed, it is possible to obtain the apparatus for compensating for a quantization error which can produce the detected value of high resolution. Consequently, although the frequency of the clock signal used for the digitalization is selected to be within the operation frequency of the ordinary digital IC, it is possible to obtain the satisfactory accuracy.

## Claims

1. An apparatus for detecting a pulse width of a pulse signal (VEL 1) comprising:
input pulse source means for generating said pulse signal;
means for generating reference clock pulses (CLK);
means (31) for producing a synchronized pulse signal (VEL2) by synchronizing the leading and trailing edges of said original pulse signal (VEL1) to the respective next occurring leading edge of said reference clock pulses (CLK),
detecting means (40) for detecting a timing difference between the leading/trailing edges of said original pulse signal (VEL1) and said synchronized pulse signal (VEL2), respectively, said detecting means (40) including
    - a first detector (41) for detecting a first timing difference between the leading edge of said synchronized pulse signal (VEL2) and the leading edge of said original pulse signal (VEL1) and for producing a first output signal (ERRH) whose pulse width indicates said first timing difference, and

- a second detector (42) for detecting a second timing difference between the trailing edge of said synchronized pulse signal (VEL2) and the trailing edge of said original pulse signal (VEL1) and for producing a second output signal (ERRL) whose pulse width indicates said second timing difference;

a converting circuit (43, 44, C) for converting said first and second output signals (ERRH, ERRL) into an analogue signal (VC) which corresponds to the difference between the duration of said first and second output signals (ERRH, ERRL) and thereby to the timing difference (T1-T2) between said original pulse signal (VEL1) and said synchronized pulse signal (VEL2);

counting means (33, 34, 35) arranged for counting the reference clock pulses (CLK) appearing during the existence of said synchronized pulse signal (VEL2) and producing a count value (CNTX) indicating pulse width of said synchronized pulse signal (VEL2); and

compensating means (50) for compensating said count value (CNTX) in response to said analogue signal (VC), said compensating means

- having digital-to-analogue converting means (35) for digital-to-analogue converting said count value (CNTX) and analogue adding means (52) for adding said analogue value (VC) and the output (V0UT0) of said digital-to-analogue converting means (35),
- or having analogue-to-digital converting means (60) for analogue-to-digital converting said analogue data (VC) and digital adding means (62) for adding said count value (CNTX) and the output (VCD) of said analogue-to-digital converting means (60),

said compensating means generating a pulse width signal having a less quantization error.

**2.** The apparatus according to claim 1, characterized in that said converting circuit includes a capacitor (C) and charge and discharge circuits (43, 44) for charging and discharging said capacitor (C) in response to said error signals (ERRH, ERRL) of said first and second detectors (41, 42), respectively.

**3.** The apparatus according to anyone of claims 1 or 2, characterized in that said counting means includes a counter (33), a latch circuit (34) connected to said counter (33) and a digital-to-analogue converter (35) connected to said latch circuit (34).

**4.** A servo circuit for controlling a motor (1), characterized in:

the input pulse source means (2A, 2B, 10A, 10B, 11) generating a pulse signal (VEL1) indicating a rotating speed of said motor (1);

an apparatus for detecting the pulse width of said pulse signal according to any one of claims 1 to 3; and

means (4) for driving said motor (1) in response to the output signal (V0UT1) of said compensating means (50) of said apparatus.

## Revendications

**1.** Dispositif pour détecter la largeur d'impulsion d'un signal pulsé (VEL1), comprenant:

un moyen à source d'impulsions d'entrée pour engendrer ledit signal pulsé;

un moyen pour engendrer des impulsions d'horloge de référence (CLK);

un moyen (31) pour produire un signal pulsé synchronisé (VEL2) en synchronisant les fronts avant et arrière dudit signal pulsé initial (VEL1) par rapport au front avant se produisant à la suite respectif desdites impulsions d'horloge de référence (CLK);

un moyen détecteur (40) pour détecter la différence de temps de synchronisation entre les fronts avant/ arrière dudit signal pulsé initial (VEL1) et dudit signal pulsé synchronisé (VEL2), respectivement, ledit moyen détecteur (40) incluant

- un premier détecteur (41) pour détecter une première différence de temps de synchronisation entre le front avant dudit signal pulsé synchronisé (VEL2) et le front avant dudit signal pulsé initial (VEL1) et pour produire un premier signal de sortie (ERRH) dont la largeur d'impulsion indique ladite première différence de temps de synchronisation, et
- un deuxième détecteur (42) pour détecter une deuxième différence de temps de synchronisation entre le front arrière dudit signal pulsé synchronisé (VEL2) et le front arrière dudit signal pulsé initial (VEL1) et pour produire un deuxième signal de sortie (ERRL) dont la largeur d'impulsion indique ladite deuxième différence de temps de synchronisation;

un circuit convertisseur (43,44,C) pour convertir lesdits premier et deuxième signaux de sortie (ERRH,ERRL) en un signal analogique (VC) qui correspond à la différence entre la durée desdits premier et deuxième signaux de sortie (ERRH, ERRL) et, de la sorte,à la différence de temps de synchronisation (T1-T2) entre ledit signal pulsé initial (VEL1) et ledit signal pulsé synchronisé (VEL2);
un moyen compteur (33,34,35) agencé pour compter les impulsions d'horloge de référence (CLK) apparaissant pendant la présence dudit signal pulsé synchronisé (VEL2) et pour produire une valeur de compte (CNTX) indiquant la largeur d'impulsion dudit signal pulsé synchronisé (VEL2); et
un moyen compensateur (50) pour compenser ladite valeur de compte (CNTX) en réponse audit signal analogique (VC), ledit moyen compensateur comportant:

- un moyen convertisseur numérique-analogique (35) pour convertir de numérique en analogique ladite valeur de compte (CNTX) et un moyen additionneur analogique (52) pour additionner ladite valeur analogique (VC) et le signal de sortie (VOUTO) dudit moyen convertisseur numérique-analogique (35), ou
- un moyen convertisseur analogique-numérique (60) pour convertir d'analogique en numérique ladite donnée analogique (VC) et un moyen additionneur numérique (62) pour additionner ladite valeur de compte (CNTX) et le signal de sortie (VCD) dudit moyen convertisseur analogique-numérique (60),

ledit moyen compensateur engendrant un signal de largeur d'impulsion comportant une erreur de quantification inférieure.

2. Dispositif selon la revendication 1, caractérisé en ce que ledit circuit convertisseur comprend un condensateur (C) et des circuits de charge et de décharge (43,44) pour charger et décharger ledit condensateur (C) en réponse auxdits signaux d'erreur (ERRH,ERRL) desdits premier et deuxième détecteurs (41,42)-,respectivement.

3. Dispositif selon l'une quelconque des revendications 1 et 2, caractérisé en ce que ledit moyen compteur comprend un compteur (33), un circuit de verrouillage (34) connecté audit compteur (33) et un convertisseur numérique-analogique (35) connecté audit circuit de verrouillage (34).

4. Circuit d'asservissement pour commander un moteur (1), caractérisé par
ledit moyen à source d'impulsions d'entrée (2A, 2B,10A,10B,11) qui engendre un signal pulsé (VEL1) indiquant la vitesse de rotation dudit moteur (1);
un dispositif pour détecter la largeur d'impulsion dudit signal pulsé selon l'une quelconque des revendications 1 à 3; et
un moyen (4) pour entraîner ledit moteur (1) en réponse au signal de sortie (VOUT1) dudit moyen compensateur (50) dudit dispositif.

## Ansprüche

1. Vorrichtung zur Erfassung einer Impulsbreite eines Impulssignals (VEL1), mit
einer Eingangsimpulsquelle zum Erzeugen des Impulssignals,
einem Mittel zum Erzeugen eines Referenztaktimpulses (CLK),
einem Mittel (31) zum Erzeugen eines synchronisierten Impulssignals (VEL2) durch Synchronisieren der Vorder- und Rückflanken des Orignal-Impulssignals (VEL1) mit der betreffenden als nächste auftretenden Vorderflanke des Referenztaktimpulses (CLK),
einem Erfassungsmittel (40) zum Erfassen einer Zeitdifferenz zwischen den Vorder- bzw. Rückflanken des Original-Impulssignals (VEL1) und des synchronisierten Impulssignals (VEL2), wobei das Erfassungsmittel (40) enthält:

- einen ersten Detektor (41) zum Erfassen einer ersten Zeitdifferenz zwischen der Vorderflanke des synchronisierten Impulssignals (VEL2) und der Vorderflanke des Original-Impulssignals (VEL1) und zum Erzeugen eines ersten Ausgangssignals (ERRH), dessen Impulsbreite die erste Zeitdifferenz angibt, und
- einen zweiten Detektor (42) zum Erfassen einer zweiten Zeitdifferenz zwischen der Rückflanke des synchronisierten Impulssignals (VEL2) und der Rückflanke des Original-Impulssignals (VEL1) und zum Erzeugen eines zweiten Ausgangssignals (ERRL), dessen Impulsbreite die zweite Zeitdifferenz angibt,

einerWandlerschaltung (43, 44, C) zum Wandeln des ersten und des zweiten Ausgangssignals (ERRH, ERRL) in ein analoges Signal (VC), das der Differenz zwischen der Dauer des ersten und des zweiten Ausgangssignals (ERRH, ERRL) und dadurch der Zeitdifferenz (T1-T2) zwischen dem Original -Impulssignal (VEL1) und dem synchronisierten Impulssignal (VEL2) entspricht,
einem Zählmittel (33, 34, 35), das vorgesehen ist zum Abzählen der Referenztaktimpulse (CLK), die während des Vorhandenseins des synchronisierten Impulssignals (VEL2) auftreten, und zum Erzeugen eines Zählwerts (CNTX), der die Impulsbreite des synchronisierten Impulssignals (VEL2) angibt, und
einem Kompensationsmittel (50) zum Kompensieren des Zählwerts (CNTX) in Reaktion auf das analoge Signal (VC), wobei das Kompensationsmittel enthält:

- einen Digital/Analog-Wandler (35) zum Digital/Analog-Wandeln des Zählwerts (CNTX) und einen Analogaddierer (52) zum Addieren des Analogwerts (VC) und des Ausgangssignals (VOUTO) des Digital/Analog-Wandlers (35), oder
- einen Analog/Digital-Wandler (60) zum Analog/Digital-Wandeln der Analogdaten (VC) und einen Digitaladdierer (62) zum Addieren des Zählwerts (CNTX) und des Ausgangssignals (VCD) des Analog/Digital-Wandlers (60), wobei das Kompensationsmittel ein Impulsbreitensignal erzeugt, das einen geringeren Quantisierungsfehler aufweist.

2. Vorrichtung nach Anspruch 1, dadurch **gekennzeichnet,** daß die Wandlerschaltung einen Kondensator (C) und Lade- und Entladeschaltungen (43, 44) zum Laden und Entladen des Kondensators (C) in Reaktion auf die Fehlersignale (ERRH, ERRL) des ersten bzw. des zweiten Detektors (41, 42) enthält.

3. Vorrichtung nach einem der Ansprüche 1 oder 2, dadurch **gekennzeichnet,** daß das Zählmittel einen Zähler (33), eine Halteschaltung (34), die mit dem Zähler (33) verbunden ist, und einen Digital/Analog-Wandler (35), der mit der Halteschaltung (34) verbunden ist, enthält.

4. Servoschaltung zum Regeln eines Motors (1), **gekennzeichnet** durch eine Eingangsimpulsquelle (2A, 2B, 10A, 10B, 11), die ein Impulssignal (VEL1) erzeugt, das eine Drehzahl des Motors (1) angibt,
eine Vorrichtung zum Erfassen der Impulsbreite des Impulssignals entsprechend einem der Ansprüche 1 bis 3, und ein Mittel (4) zum Treiben des Motors (1) in Reaktion auf das Ausgangssignal (VOUT1) des Kompensationsmittels (50) der Vorrichtung.

FIG. 1

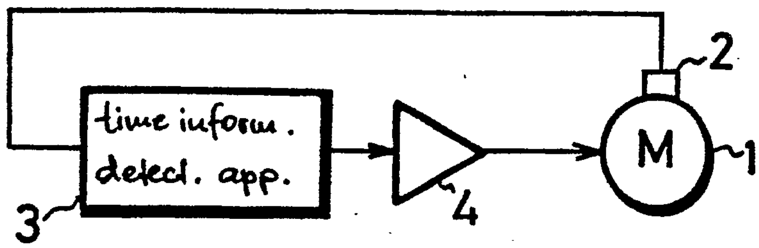


FIG. 2

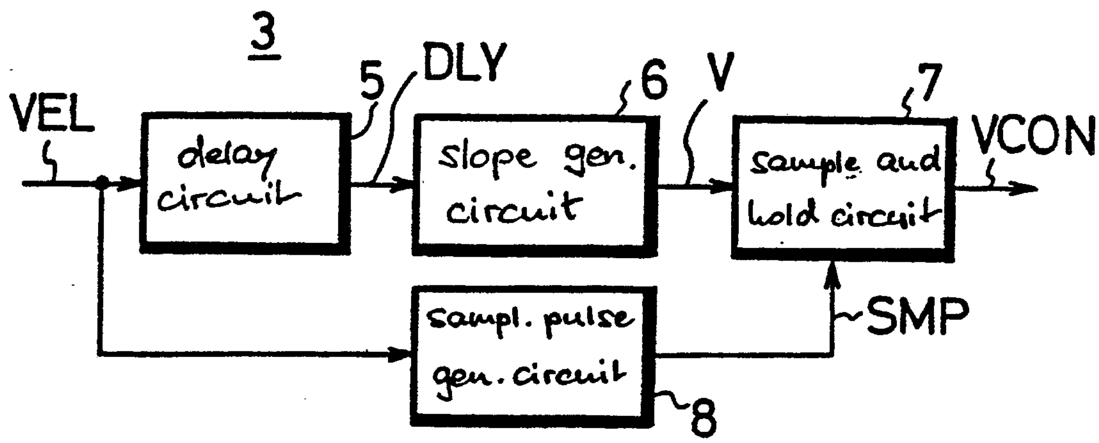


FIG. 3A

FIG. 3B

FIG. 3C

FIG. 3D

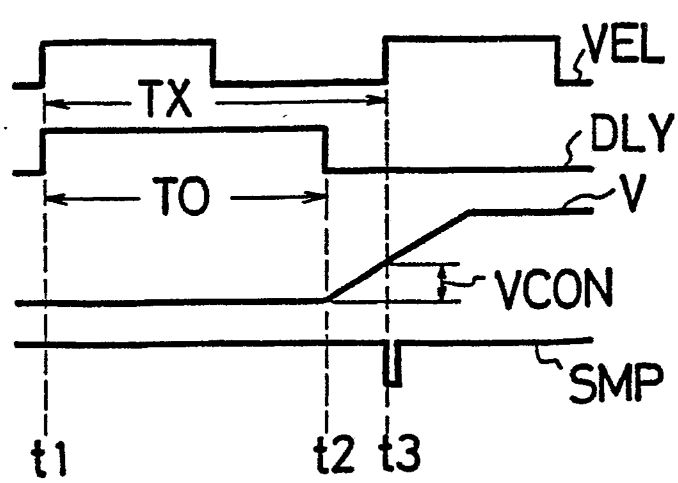

FIG. 4

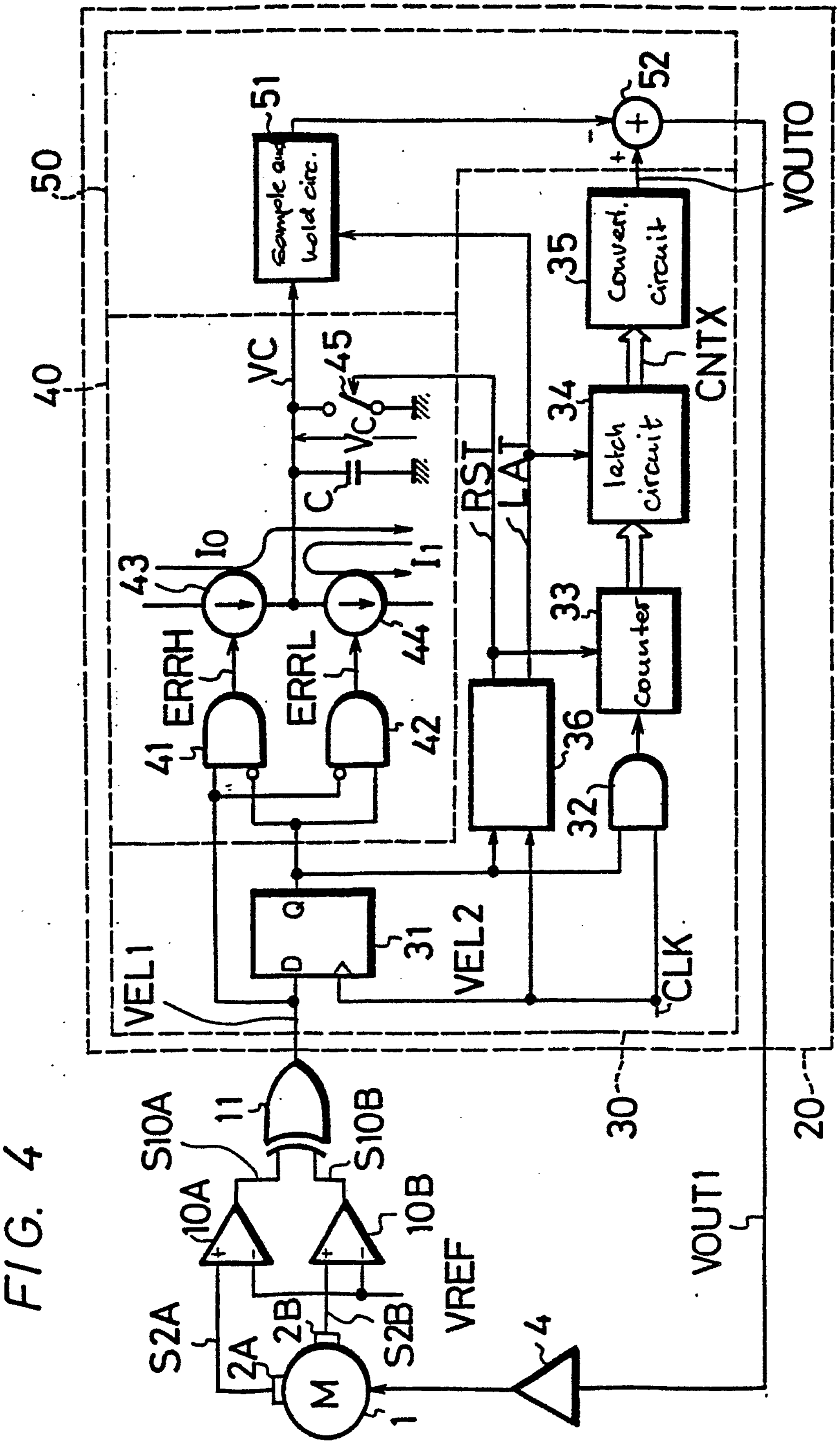
50
40
51
52
Sample and hold circ.
VOUTO
VC
45
Vc
C
RST
LAT
I0
I1
43
44
ERRH
ERRL
41
42
36
33
34
35
Counter
latch circuit
Convert. circuit
CNTX
32
31
D
Q
VEL1
VEL2
CLK
11
S10A
S10B
10A
10B
VREF
S2A
S2B
2A
2B
M
1
4
VOUT1
30
20

FIG. 5A
FIG. 5B
FIG. 5C
FIG. 5D
FIG. 5E
FIG. 5F
FIG. 5G

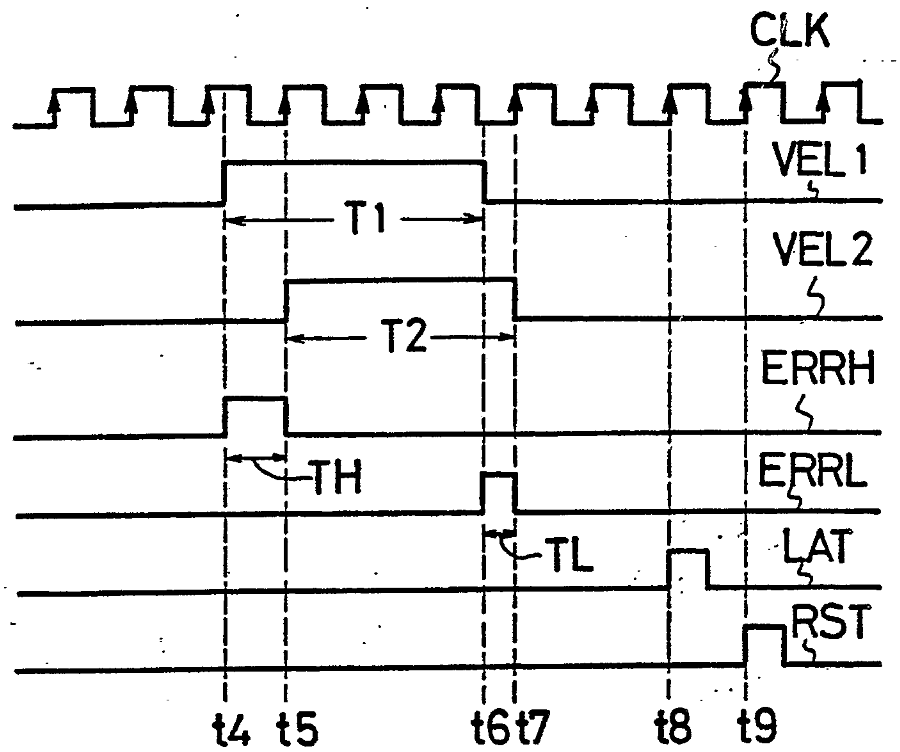


FIG. 6